# EUROPEAN PATENT APPLICATION

(11) **EP 2 570 947 A1**
(43) Date of publication of application: **20.03.2013**
(21) Application number: 11777095.8
(22) Date of filing: 21.01.2011
(51) Int. Cl.: G06F 17/50

(54) **FASTENER MODEL REPRESENTATION DEVICE AND METHOD FOR USE IN FASTENER-AIDED DESIGN SYSTEM**

(30) Priority: 06.05.2010 CN 201010168423
(71) Applicant: Commercial Aircraft Corporation Of China Ltd, Shanghai 200120 (CN); Commercial Aircraft Corporation Of China Ltd Shanghai Aircraft Design and Research Institute, Shanghai 201210 (CN)
(72) Inventor: WU, Guanghui, Shanghai 200120 (CN); HAN, Kecen, Shanghai 201210 (CN); ZHOU, Liangdao, Shanghai 201210 (CN); LV, Jun, Shanghai 201210 (CN); WANG, Bing, Shanghai 201210 (CN); JIANG, Yu, Shanghai 201210 (CN); CHEN, Lufeng, Shanghai 201210 (CN)
(74) Representative: Bergmeier, Werner
(86) International application number: PCT/CN2011/070477
(87) International publication number: WO 2011/137674

(57) **Abstract**

A fastener model representation device (10) for use in a fastener-aided design system includes: at least one fastener model (101, 102) which comprises an Information memory module (1011 , 1021) for storing three-dimensional information of the fastener model (101, 102). Also provided, and corresponding to the aforementioned device, is a fastener model representation method for use in a fastener-aided design system. By storing the three-dimensional information of the fastener model into the local storage area of the fastener model and directly accessing the information, various graphic representations of the fastener model and statistical information about the fastener model can be provided to the user for browsing, editing, modifying or configuring. At the same time, specific graphical representations in the form of lines and circles make the illustrative representations of the fastener models easier to read.

## Description

### Field of the invention

The present invention relates to the field of fastener aid design, and particularly to a fastener model representation device and method in a fastener aid design system in airplane structure design.

### Background of the invention

In conventional airplane design, fastener representation mainly relies on two-dimensional drawings. Distribution workload of drawings is great, frequent alteration of drawings might cause careless omission and errors, spatial position is not easily represented, coordination is not direct and a low efficiency is exhibited, and a designer's too much time and energy is occupied. In a certain sense, current fastener design and representation method have already become a bottleneck limiting the designer's design work.

Use of entity fasteners is a common full three-dimensional representation form, but assembling all fasteners as individual entity parts to a corresponding product causes an over-complicated product structure in the design software, a large number of parts and complicated assembling. It is difficult to put into practice for aircraft structure design of hundreds of thousands of fasteners.

### Summary of the invention

In view of the above technical problems, the present invention provides a fastener model representation device and method in a fastener aid design system, which can provide a user with various graphic representations and statistic information of the fastener model, enable the user to browse and make any edition, amendment or configuration according to design needs, improve operability and easy use for the user in the fastener design, and meanwhile make fastener model graphic legends of the device more visual and comprehensible.

According to an embodiment of the present invention, it is provided a fastener model representation device in a fastener aid design system, comprising: at least one fastener model. The fastener model comprises an information storage module configured to store naming information and three-dimensional information of the fastener model.

According to one embodiment of the present invention, it is provided a visual method for representing the fastener model: using a full three-dimensional fastener representation method of feature lines and circles and using a method of feature points and feature lines with a minimum data size to define fastener information, wherein a shaft-like fastener model is represented with a line-segment graphic element; an annular fastener model is represented by a circular graphic element; anchor nut-like directional fastener model is represented with a circle with two line segments.

According to one embodiment of the present invention, it is provided a fastener model representation method in a fastener aid design system, comprising steps of: storing the three-dimensional information related to the fastener model in a local storage area of the fastener model; performing graphic representation display of the fastener model according to the three-dimensional information of the fastener model.

By means of the device and method of the present invention, the three-dimensional information of the fastener model is stored in the local storage area of the fastener model and may be directly accessed so that the three-dimensional information of the fastener model may be accessed and calculated, thereby providing users with various graphic representations of the fastener model and statistic information of the fastener model, enabling the user to browse and make any edition, amendment or configuration, and meanwhile making fastener model graphic legends of the device more visual and comprehensible by using specific graphic representation forms with lines and circles as features.

### Brief description of drawings

Other features, objectives and advantages of present invention will be made more apparent by reading the following detailed description of non-restrictive embodiments with reference to drawing.
- **Fig. 1**: is a structural block diagram of a fastener model representation device in a fastener aid design system according to an embodiment of the present invention;
- **Fig. 2**: is a structural block diagram of a fastener model representation device in a fastener aid design system according to another embodiment of the present invention;
- **Fig. 3**: is a flowchart of a fastener model representation method in a fastener aid design system according to an embodiment of the present invention;
- **Fig. 4**: is a structural view of a graphic representation of a fastener model including a plurality of graphic elements in a fastener aid design system according to an embodiment of the present invention;
- **Fig. 5**: is a distribution view of a fastener model with symmetrical positions in a fastener-aided design system according to an embodiment of the present invention;
- **Fig. 6**: is a distribution view of the fastener model in Fig. 5 in a global representation mode;

Wherein identical or like reference numerals denote identical or similar step features or means (modules).

### Detailed description of preferred embodiments

Exemplary description of specific embodiments of the present invention will be presented in detail with reference to figures.

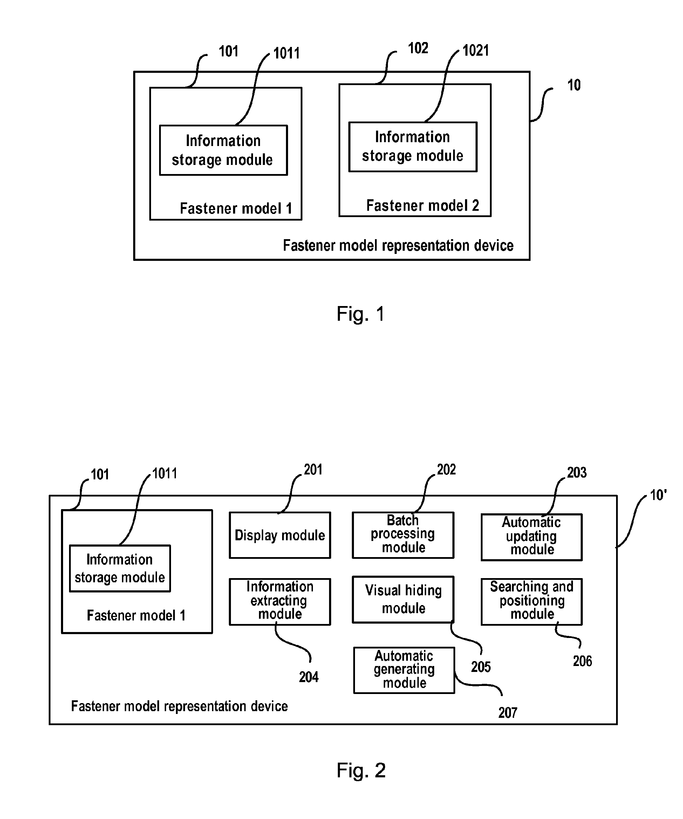

Fig. 1 is a structural block diagram of a fastener model representation device in a fastener aid design system according to an embodiment of the present invention. The fastener model representation device 10 comprises two fastener models 101, 102 which respectively include an information storage module 1011, 1021.
Fig. 2 is a structural block diagram of a fastener model representation device in a fastener aid design system according to another embodiment of the present invention. The fastener model representation device 10' in the embodiment comprises, besides the fastener model 101 and the information storage module 1011 included by it, a display module 201, a batch processing module 202, an automatic updating module 203, an information extracting module 204, a visual hidden module 205, a searching and positioning module 206, and automatic generating module 207.

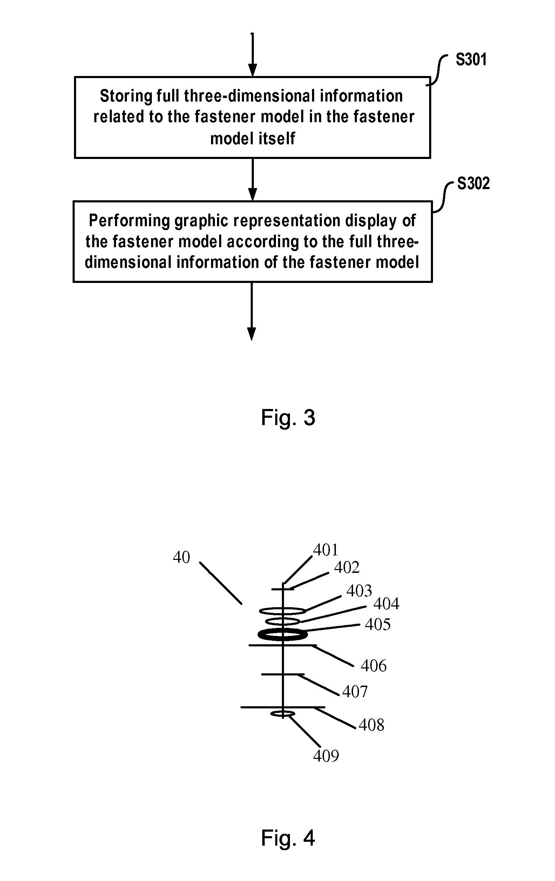

Fig. 4 is a structural view of a graphic representation of a fastener model including a plurality of graphic elements in a fastener aid design system according to an embodiment of the present invention. The graphic elements included in graphic representation 40 are: a bolt 401, a cotter pin 402, a nut 403, washers 404, 405, fastening surfaces 406, 408, a cooperating surface 407 and a washer 409.

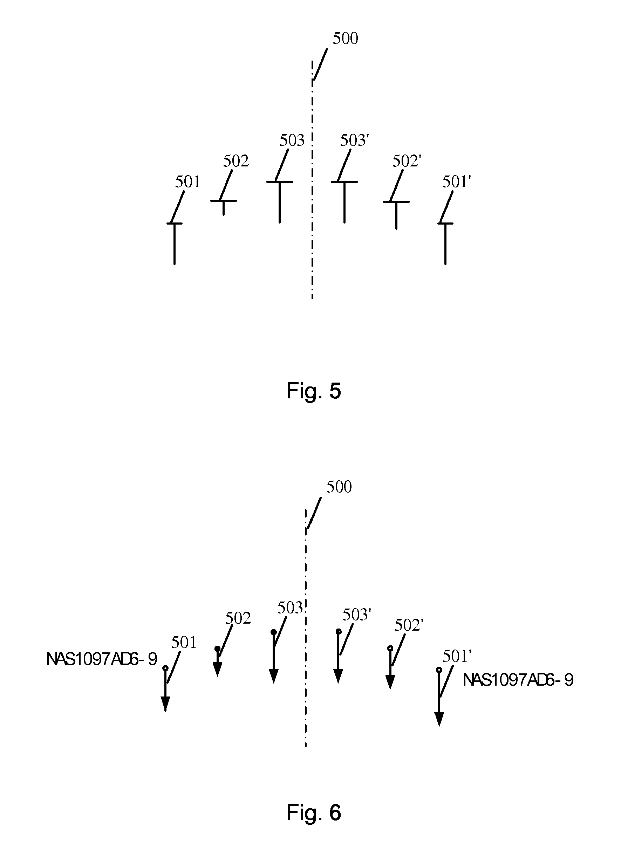

Fig. 5 is a distribution view of a fastener model with symmetrical positions in a fastener aid design system according to an embodiment of the present invention, wherein two sets of fastener models 501, 502, 503 and 501', 502', 503' are symmetrical about an axis 500 at geometrical positions.

Referring to Fig. 1, Fig. 2, Fig. 4 and Fig. 5, the fastener model representation device in the fastener aid design system according to the present invention will be further described in detail.

An embodiment of the fastener model representation device 10 in the fastener aid design system (not shown in the figure) according to the present invention comprises: two fastener models 101, 102 which respectively include an information storage modules 1011, 1021 for respectively storing 3-dimensional information of the fastener models 101, 102, wherein the 3-dimensional information can be obtained by the fastener aid design system via direct access.

Another embodiment of the fastener model representation device 10' in the fastener aid design system (not shown in the figure) according to the present invention comprises one fastener model 101 which includes an information storage module 1011 for storing 3-dimensional information of the fastener model 101, wherein the 3-dimensional information can be obtained by the fastener aid design system via direct access.

Alternatively, the above representation device 10' further comprises a display module 201 configured to perform graphic representation of the fastener model 101 according to the three-dimensional information stored by the information storage module 1011 of the fastener model 101.

Alternatively, the information storage module 1011 in the above representation device 10' is further configured to store other related information of the fastener model 101. These related information includes a part number (e.g., NAS1097AD6-9) of the fastener model 101, and one or more of a name of the fastener model (e.g., aluminum alloy, Titanium-Niobium alloy 100 degree solid rivet), an identification number (e.g., 0860), weight (e.g., 30g), installation standards, connected parts (e.g., a bi-layered steel plate), amendment information, coordinates, materials, heat treatment, detail parameter and mechanical property. Property information of the fasteners of the same class is shared in a manner of digital dictionary.

Alternatively, the fastener model representation device 10' further comprises an information extracting module 204 configured to partially or totally obtain the three-dimensional information and/or other related information of the fastener model 101 or 102 stored in the information storage module, and display the obtained three-dimensional information and/or other related information on the display module 201. The information displayed on the display module 201 is classified and restrictively displayed according to needs of different processes such as design and assembly, for example, other related information may be only displayed for the assembling process, while the three-dimensional information and all other related information may be displayed for a user in the design stage.

Alternatively, the three-dimensional information of the fastener model representation device specifically comprises an installation position (e.g., an installation position on a three-dimensional position point on an aerofoil) of the fastener model 101, an installation direction (e.g., the installation direction is identified by an upward normal direction of a fastener installation plane or with three-dimensional coordinates) and a length (e.g., 13cm).

Alternatively, in the graphic representation of the fastener model representation device 10', the fastener model is represented one to one with graphic elements. As shown in Fig. 4, a shaft-like fastener model such as a bolt or a high lock bolt, a nail (e.g., a screw or a ring groove nail) is represented with a line-segment graphic element 401; an annular fastener model such as a nut or a high-lock nut is represented by a circular graphic element 403; an annular fastener model such as a washer is represented by circular graphic elements 404, 405. There are two layers of washers in the present embodiment. Those skilled in the art should appreciate that only one layer of washer may be used here, and the annular fastener model may be a nail sleeve in other embodiments; anchor nut-like directional fastener model is represented with a circle with two line segments.

Alternatively, in the graphic representation of the fastener model representation device 10', as shown in Fig. 4, a washer with a diameter of 3cm is represented by a circular graphic element 404 with a smaller diameter, and a washer with a diameter of 5cm is represented by a circular graphic element 405 with a larger diameter. Those skilled in the art should appreciate that in other embodiments, the three-dimensional information of the fastener model is represented proportionally in a form of a color and an arrow. Preferably, the three-dimensional information of the fastener model 101 may be represented with the above thick and thin line types and length in a 1:1 proportion to increase the user's legibility.

Alternatively, the above fastener model representation device 10' further comprises simplifying self-defining module (not shown) configured to perform graphic representation of the set of fastener models 101 in the form of points according to the three-dimensional information, that is, each point in the view represents the set of fasteners in a project. Alternatively, in response to an operation of the point by the mouse, the simplifying self-defining module is further configured to display the three-dimensional information on the fastener model 101 on the display module 201, define the fastener part number in properties of "points" in a specific set with semi-colon ";" in between (e.g., NAS1466; NAS1080-06). A check of weight and gravity center statistics, a margin and spacing can also be performed with respect to the fastener of a simple representation method of the above simplifying self-defining module.

Alternatively, the above fastener model representation device 10' further comprises a visual hidden module 205 configured to receive a display portion which is of the graphic representation in the display module 201 and selected by the user, and only display on the display module the selected display portion of the graphic representation, and hide unselected display portion so that the user can only see the selected graphic representation portion on the display module and may enlarge or reduce it.

Alternatively, the fastener model representation device 10' further comprises a statistic module (not shown) configured to obtain design information of the fastener model 101 according to the three-dimensional information of the fastener model 101. Preferably, in the representation device of the fastener model in the present embodiment, the design information comprises a part number (e.g., NAS1097AD6-9), a name, the quantity, weight, center of gravity and the like of the fastener model, wherein the center of gravity needs to be obtained by calculation according to geometrical parameters included in the three-dimensional information of the fasteners.

Alternatively, the fastener model representation device 10' further comprises an automatic updating module 203 configured to automatically update information (e.g., a bolt length) of the information storage module according to a change (e.g., a change of connected parts in dimensions caused by user's replacement of parts) according to dimensions (such as thickness) of parts connected by the fastener model. Preferably, the automatic updating module 203 performs corresponding proportional graphic representation on the display module 201 according to updated dimensions (e.g., a bolt length) information. Preferably, the above updated information includes the installation position, length, part number of the fastener model and the like. Alternatively, the fastener model representation device 10' further comprises a batch processing module 202 configured to correspondingly give the three-dimensional information and other properties stored in the three fastener models 501, 502, 503 selected by the user and shown in Fig. 5 to three newly-built fastener models 501', 502', 503', and perform graphic representation of the fastener model 501', 502', 503' on the display module 201; alternatively, the fastener model representation device 10' further comprises a calculating module (not shown) configured to calculate and adjust the respective three-dimensional information of the newly-built fastener models 501', 502', 503' according to specific parts connected by the newly-built fastener models 501', 502', 503', for example, in Fig. 5 a thickness of the part connected at the fastener model 502' is 5cm, greater than a thickness 3cm of the part connected by the corresponding fastener model 502, then the calculating module calculates and adjusts the length of the bolt according to specific parts connected by the newly-built fastener model 502', and represents the length of the fastener model with a vertical line segment length longer than the fastener model 502 (e.g., 5cm) in a graphic representation manner.

Alternatively, the fastener model representation device 10' further comprises a searching and positioning module 206, wherein the fastener model 101 is provided with a sole identification such as 0657, the fastener model 102 is provided with a sole identification such as 0659, the searching and positioning module 206 searches and positions the fastener model according to the sole identifications of the fastener models 101, 102; and perform graphic representation of the searched and positioned fastener model on the display module 201, i.e., display on the display module 201 in a thumbnail or a schematic diagram in a T shape as shown in Fig. 5. Since the above identifications 0657, 0659 are sole in a design project, therefore, according to the identifications, the searching and positioning module 206 can be used to solely and accurately determine the position of the fastener model in the airplane and its three-dimensional information and other related information.

Alternatively, the fastener model representation device 10' further comprises a global representing module (not shown) configured to perform, according to the three-dimensional information of the fastener models 501, 502, 503 and 501', 502', 503', graphic representation of the above fastener models on the display module 201 in the form of a vector and annotation. As shown in Fig. 6, an installation direction of the fastener model is represented with a vector at a lower end of the vertical line; the part number of the fastener model such as the part number NAS1097AD6-9 displayed beside the fastener models 501, 501' shown in Fig. 6 is represented with annotated verbal information.

Alternatively, the fastener model representation device 10' further comprises an automatic generating module 207 configured to automatically generate, after the part number being determined, feature lines and related information thereof corresponding to a combination of the fastener models and establish association with the connected parts through choosing the position points of the fastener models and parts connected by upper and lower layers thereof. After the related part is determined by clicking the mouse, the automatic generating module 207 automatically extracts related parameter information to generate feature line/circle to ensure features of all fastener models accurate and uniform and establish association with the connected parts. All information of the fasteners includes for example a part number (e.g., NAS1097AD6-9), a name (e.g., aluminum alloy, Titanium-Niobium alloy 100 degree solid rivet), an identification number (e.g., 0860), weight (e.g., 30g), installation standards, connected parts (e.g., a bi-layered steel plate), amendment information, coordinates, materials, heat treatment, detail parameter and mechanical property of the fastener models. The fasteners with the same part number share property information in a manner of digital dictionary to achieve light weight of the model volume.

Fig. 3 is a flowchart of a fastener model representation method in a fastener aid design system according to an embodiment of the present invention. The fastener model representation method comprises the following steps:
First, performing step S301: storing the three-dimensional information related to the fastener model in a local storage area of the fastener model;

Then, performing step S302: performing graphic representation display of the fastener model according to the three-dimensional information of the fastener model.

It is appreciated that the above embodiments are only exemplary and not intended to limit the present invention. Any technical solutions without departing from the spirit of the present invention shall fall within the protection scope of the present invention, which means that different technical features appearing in different embodiments may be combined to achieve an advantageous effect. Besides, any reference number in claims shall not be considered as limiting said claims; the word "comprising" does not exclude devices or steps not listed in other claims or the description; "a" before a device does not exclude existence of a plurality of said devices; in an apparatus including a plurality of devices, functions of one or more of the plurality of devices may be implemented by the same hardware or software module; words such as "a first", "a second" and "a third" are only used to designate a name not to designate any specific order.

## Claims

1. A fastener model representation device in a fastener aid design system, comprising: at least one fastener model, **characterized in that**, the fastener model comprises an information storage module configured to store naming information and three-dimensional information of the fastener model.

2. The device according to claim 1, wherein the naming information comprises part number.

3. The device according to claim 2, further comprising: a display module configured to perform graphic representation of the fastener model according to the three-dimensional information of the fastener model.

4. The device according to claim 3, wherein the information storage module is further configured to store related information of the fastener model, the related information includes at least one of a name, an identification number, weight, installation standards, connected parts, amendment information, coordinates, materials, heat treatment, detail parameters and mechanical properties of the fastener model; the related information and the naming information are shared by the fasteners of the same class in a manner of a digital dictionary.

5. The device according to claim 4, further comprising: automatic generating module configured to automatically generate, after the part number being determined, feature lines and the related information corresponding to a combination of the fastener models and establish association with the connected parts through choosing the position points of the fastener models and parts connected by upper and lower layers thereof.

6. The device according to claim 4 or 5, further comprising: information extracting module configured to partially or totally obtain the three-dimensional information and/or related information of the fastener model stored in the information storage module, and display the obtained three-dimensional information and/or related information on the display module.

7. The device according to claim 3, wherein the three-dimensional information comprises an installation position, an installation direction and a length of the fastener model.

8. The device according to claim 7, wherein in the graphic representation, the fastener model is represented correspondingly with graphic elements which are capable of representing the fastener features.

9. The device according to claim 8, wherein a shaft-like fastener model is represented with a line-segment graphic element, an annular fastener model is represented by a circular graphic element, an anchor nut-like directional fastener model is represented with a circle with two line segments, wherein a cotter pin-like fastener model is represented by line segments without endpoints and intersects with the feature lines of the shaft-like fastener model.

10. The device according to claim 9, wherein the shaft-like fastener model is a bolt, a high lock bolt, a nail or a ring groove nail.

11. The device according to claim 9, wherein the annular fastener model is a nut, a high lock nut, a nail sleeve, a washer or a bushing.

12. The device according to claim 9, wherein the graphic elements proportionally represent the three-dimensional information of the fastener model in a form of the line segments by means of thickness, length, color and arrow thereof.

13. The device according to claim 3, further comprising a simplifying self-defining module configured to perform graphic representation of the set of fastener models in the form of points according to the three-dimensional information.

14. The device according to claim 13, wherein in response to an operation of the point by the mouse, the simplifying self-defining module displays the three-dimensional information of the fastener model on the display module.

15. The device according to claim 3, further comprising: a visual hiding module configured to receive a display portion which is of the graphic representation and selected by the user, and only display on the display module the selected display portion of the graphic representation.

16. The device according to claim 2 or 3, further comprising: a statistic module configured to obtain design information of the fastener model according to the three-dimensional information of the fastener model.

17. The device according to claim 16, wherein the design information comprises the part number, the quantity, the center of gravity, the name and the weight.

18. The device according to claim 3 or 5, further comprising: a batch processing module configured to correspondingly give in a batch the related information of the fastener model selected by the user to newly-built fastener models, and perform graphic representation of the fastener models on the display module; and a calculating module configured to calculate the three-dimensional information of the newly-built fastener models according to parts connected by the fastener models.

19. The device according to claim 2 or 3, further comprising: an automatic updating module configured to automatically update information of the information storage module according to a change of dimensions of parts connected by the fastener model.

20. The device according to claim 3, further comprising: an automatic updating module configured to automatically update information of the information storage module according to a change of dimensions of parts connected by the fastener model, and perform graphic representation of the fastener model on the display module according to the updated information.

21. The device according to claim 19 or 20, wherein the updated information includes the part number, the installation position and the length of the fastener model.

22. The device according to claim 3, further comprising a searching and positioning module, wherein the fastener model is provided with a sole identification, and the searching and positioning module is configured to search and position the fastener model according to the sole identification of the fastener model, and perform graphic representation of the searched and positioned fastener model on the display module.

23. The device according to claim 3, further comprising a global representing module configured to perform, according to the three-dimensional information, graphic representation of a plurality of fastener models on the display module in the form of a vector and annotation, wherein an installation direction of the fastener model is represented with the vector, and the part number of the fastener model is represented with annotated verbal information.

24. A fastener model representation method in a fastener aid design system, comprising steps of:
storing naming information and three-dimensional information related to the fastener model in a local storage area of the fastener model;
performing graphic representation display of the fastener model according to the three-dimensional information of the fastener model.
